# EUROPEAN PATENT APPLICATION

(11) **EP 2 693 465 A1**
(43) Date of publication of application: **05.02.2014**
(21) Application number: 12178628.9
(22) Date of filing: 31.07.2012
(51) Int. Cl.: H01L 21/60, H01L 23/48

(54) **Electronic device and method of manufacturing such device**

(71) Applicant: NXP B.V., 5656 AG Eindhoven (NL)
(72) Inventor: Rijckevorsel, Johannes Wilhelmus, 5656 AG Eindhoven (NL); Dijkstra, Paul, 5656 AG Eindhoven (NL); De Langen, Michel, 5656 AG Eindhoven (NL); Bruin, Emiel, 5656 AG Eindhoven (NL)
(74) Representative: Krott, Michel

(57) **Abstract**

The invention relates to a method of manufacturing a semiconductor device (1'). The method comprises steps of: i) providing a semiconductor chip (10') comprising a silicon layer (11) at a side thereof, and further comprising a first attachment layer (13) directly on the silicon layer (11), wherein the first attachment layer (13) comprises gold; ii) heating the semiconductor chip (10') to above a predefined temperature forming an alloy layer (13') comprising gold-silicon alloy; iii) providing a second attachment layer (14) directly on the alloy layer (13'), wherein the second attachment layer (14) comprises gold; iv) providing a conductive substrate (200) for receiving the semiconductor chip (10'); v) providing the semiconductor chip (10') on a surface of the conductive substrate (200); vi) heating the assembly to a further predefined temperature above a melting point of the alloy layer (13') forming a molten alloy layer; vii) reciprocating, while maintaining the further temperature, the semiconductor chip (10') with respect to the conductive substrate (200) such that their surfaces are scrubbing each other. In the last step a solder layer is being formed comprising the molten alloy layer (13') and gold originating from the second attachment layer (14) consuming the second attachment layer (14). The reciprocating step is continued until the second attachment layer (14) is fully consumed. The method results in a further cost-down of the manufacturing method and semiconductor device.

## Description

### FIELD OF THE INVENTION

The invention relates to method of manufacturing a semiconductor device, wherein a semiconductor chip is attached to a conductive substrate. The invention relates in particular to the manufacturing of discrete power packages.

The invention further relates to such devices as such.

### BACKGROUND OF THE INVENTION

Discrete power packages are known for containing a semiconductor device or circuit but are relatively costly to achieve acceptable levels of reliability and performance. The manufacturing goal is to produce a microcircuit package having a high performance at a low cost. However, microcircuit packages of presently known construction cannot achieve intended performance levels at a low cost. In general, known microcircuit packages employ a high conductive materials with low thermal coefficient for expansion (TCE) to provide high thermal performance and high reliability.

To achieve low cost, high thermal performance and high reliability for a microcircuit package which will contain a semiconductor device or circuit, the following criteria should be met:
1. High thermal conductivity in a low cost base material;
2. Low cost intermediate material with a material properties that functions as a stress relief buffer
3. High thermal performance die attach.

Many high performance microcircuit packages are fabricated using CuMo, CuW materials with thermal dissipation structures using "flanges" of materials which have matched TCEs to the silicon die. Typical materials incorporated into discrete power packages as flanges include copper-tungsten, copper/molybdenum clad structures, and aluminum-silicon carbide (AlSiC). These materials have an advantage of TCEs fairly close to that of the semiconductor devices. Semiconductor devices typically have thermal coefficients of expansion in the range of 2.8-4.0 ppm/°C. The aforementioned flange materials have TCE values in the range of 6.0-10.0 ppm/°C. TCE values below 10.0 ppm/°C. are desirable so that expansion and contraction during temperature extremes do not cause high levels of stress to the semiconductor device which can cause the device to crack. The deficiencies in these materials are that the thermal conductivities are fairly low, i.e., in the range of 150-240 W/mK (Watt per meter Kelvin), and the cost of these materials is high.

A better flange material would be copper or a copper alloy for at least the following reasons. Copper is a material which is commonly available, has a low cost, and can be fabricated using high volume manufacturing techniques such as stamping. Also, copper and copper alloys have a thermal conductivity in the range of 350-400 W/mK. A technical barrier to using copper for flanges in these applications has been the fact that copper and copper alloys have a high TCE (about 17-20 ppm/°C). This large difference between the TCEs of copper and that of semiconductor devices has resulted in large stresses applied to the semiconductor devices which can cause a failure during operation. In addition, conventional dielectric materials used for this application are ceramic based. The large mismatch of TCE results in excessive warpage or cracking of the dielectric.

To minimize the effects of large stresses being applied to the semiconductor devices in conventional packages having copper flanges, one prior art approach employs an adhesive for the die attach. This allows use of a more ductile die attach but has a substantial drawback in that the adhesive has a very low thermal conductivity which limits the performance of the die attach. Another prior art approach uses high lead solder for the die attach, which allows use of a more ductile solder, but the high lead solder is a problem due to environmental issues. Furthermore, there are also process-related issues such as control of the layer thickness, and the co planarity of the silicon die. A further prior art approach uses a very thick layer of gold, typically 300 micro-inches (7.2µm), applied to the backside of the semiconductor die, which allows for a buffer layer of gold on the die, but the thick layer of gold adds considerable cost to the product. A gold layer has been used on the backside of a gallium arsenide die which is soldered with AuSn eutectic solder to a copper substrate, but this approach has traditionally been limited to small devices <3 mm on a side, and has been limited to devices which have a substantially square shape.

As previously noted, the TCE mismatch between the semiconductor device and the flange material results in failure of the semiconductor device or the die attach by reason of the stress induced by the TCE mismatch. In addition, when a ceramic dielectric material is used with a copper flange, the mismatch in TCE between ceramic and copper can cause large stresses to be developed in the structure, which results in excessive warpage or cracking of the dielectric. When the semiconductor device is soldered to the flange, the temperature of the solder at a liquidus point is 280°C. for gold-tin alloys, or 368°C. for a gold-silicon eutectic composition. For these eutectic compositions, the solder turns into a solidus at the aforementioned temperatures. At this solidus point a top layer of the flange material is frozen, and cooling to room temperature causes a bottom portion of the flange to contract more than the top portion, causing the flange to bend into a concave shape. This concave shape subjects the semiconductor device to a bending stress, and such a tensile stress in the semiconductor device can cause a failure of the device.

US2008/0128908A1 proposes to use a ductile layer to overcome the mismatch between the TCEs of the parts. The ductile layer then absorbs the stress between the flange and the semiconductor device.

In the prior art a method of attaching a semiconductor device to a flange using a gold-silicon solder attachment technique has been reported. In this technique a thin gold layer (typically 300nm) is provided on the back-side of the semiconductor device, whereafter an alloying step is carried out. During the alloy step the device is heated to a high temperatures (between 360°C and 400°C) which makes the gold atoms to diffuse into the silicon. At the surface a gold-silicon alloy layer is being formed. Such step is typically carried out in a wafer factory. For gold-silicon solder attachment a further gold-surface is required. Furthermore, this has to be a thick layer of gold, typically with a thickness in the range 1.5-2.5µm. This gold layer is provided on a flange. Subsequently, the semiconductor device is provided on the flange. The assembly is subsequently heated to a temperature of about 430°C. In this step the gold-silicon alloy layer will melt. Subsequently, the semiconductor device is scrubbed (moved hence and forth) over the flange, which results in the creation of a "solder bath", wherein more and more gold and silicon is dissolved into the molten gold-silicon alloy layer. After cooling down the assembly, the solder bath will solidify and the solder attachment is created.

Despite the developments reported in the prior art there is still a need for improved solutions, which make the devices less costly and the process more reliable.

### SUMMARY OF THE INVENTION

The proposed invention provides a method of manufacturing a semiconductor device, which results in a further cost-down. The invention further provides such semiconductor device as such.

The invention is defined by the independent claims. The dependent claims define advantageous embodiments.

In accordance with a first aspect of the invention a method of manufacturing a semiconductor device as described in claim 1 is provided. The method comprises:
- providing a semiconductor chip comprising a silicon layer at a side thereof, and further comprising a first attachment layer directly provided on the silicon layer, wherein the first attachment layer comprises gold, wherein the semiconductor chip comprises an active element;
- heating the semiconductor chip to above a predefined temperature at which the gold of the first attachment layer diffuses into the silicon layer forming an alloy layer comprising gold-silicon alloy consuming the first attachment layer, wherein the heating is carried out until the first attachment layer has been fully consumed;

- providing a second attachment layer directly on the alloy layer, wherein the second attachment layer comprises gold;
- providing a conductive substrate with a solderable surface for receiving the semiconductor chip;
- providing the semiconductor chip on a surface of the conductive substrate such that the second attachment layer contacts the conductive substrate forming an assembly;
- heating the assembly to a further predefined temperature above a melting point of the alloy layer forming a molten alloy layer;
- reciprocating, while maintaining the further temperature, the semiconductor chip with respect to the conductive substrate such that their surfaces are scrubbing each other, in which reciprocating step a solder layer is being formed comprising the molten alloy layer and gold originating from the second attachment layer consuming the second attachment layer, and the solder layer being formed further comprising silicon originating from the silicon layer, and which reciprocating step is continued until the second attachment layer is fully consumed such that the molten alloy layer touches the conductive substrate, and
- cooling down the assembly such that the solder layer solidifies and a solder attachment has been formed between the conductive substrate and the semiconductor chip.

The method constitutes a significant improvement over the prior art method. The inventors have discovered that, rather than providing the second attachment layer (typically a relatively thick gold) layer on the conductive substrate (flange or header), this gold layer can be provided on the back-side of the die, over the gold-silicon alloy layer. The process steps to be carried out further are effectively the same as in the prior art. A first major advantage of this method is that the amount of gold that is used is significantly reduced. A second major advantage is that the method of the invention renders it possible to use much cheaper conductive substrates having standard cheaper solderable layers, such as silver or nickel-paladium-gold alloy.

In order to facilitate the understanding of the invention a few expressions are defined hereinafter.

Throughout the description the term "high-power" implies power levels in a 10/1000µs surge pulse of the order of hundreds or even thousands of watts, i.e. 600 W or even 1500 Watt or more. In the application area of an antenna systems for cellular base stations, the power level ranges typically from 200 to 300 Watt. However, it must be stressed that, albeit that the invention is particularly advantageous in high-power applications, the invention is also advantageous in lower power applications, i.e. the prevention of short-circuits on the die, and the better wettability in case of lead-free interconnect materials.

Throughout the description the term "semiconductor chip" is defined as a carrier onto which or in which an active element (such as a diode and a transistor) is integrated. Such substrate may be a semiconductor substrate, but this is not essential (for example, a silicon-on-insulator substrate or a silicon-on-anything substrate).

Throughout the description the term "active element" is defined as an element of an electronic circuit, such as a transistor, a diode, a thyristor, etc. All such elements may be used as rectifying elements in transient voltage suppression circuits.

Throughout the description the term "terminal" is defined as an electrical connection of an active element, such as a gate connection, a drain connection, a source connection, and a bulk connection.

Throughout the description the term "interconnect material" is defined as a conductive material that is suitable for soldering parts together such that a physical, but also an electrical connection is achieved.

In an embodiment of the method of the invention the first attachment layer on semiconductor chip is chosen with a thickness in the range from 150nm to 300nm.

In an embodiment of the method of the invention the attachment second layer on the alloy layer is chosen with a thickness in the range from 0.5µm to 3.5µm, and preferably in the range from 1.5µm to 2.5µm.

In an embodiment of the method of the invention the predefined temperature is chosen in the range from 360°C to 400°C .

In an embodiment of the method of the invention the further predefined temperature is chosen in the range from 400°C to 450°C.

In accordance with a second aspect, the invention provides a semiconductor device comprising an assembly obtainable via the method of the invention, wherein the assembly comprises the semiconductor chip and the conductive substrate. The method of the invention may be applied in the manufacturing of various kinds of devices and applications. Any such device is characterized by this method in that the thick gold layer is (substantially) completely consumed and there is merely a solidified solder layer (comprising an alloy silicon and gold) in between the semiconductor chip and the surface of the conductive substrate.

In accordance with a third aspect, the invention provides a semiconductor device comprising:
- a conductive substrate;
- a solder layer provided on the conductive substrate, wherein the solder layer comprises an alloy of gold and silicon;
- a semiconductor chip provided on the solder layer, wherein the semiconductor chip comprises an active element. This is a special embodiment of the previous embodiment in the case the thick gold layer has been completely consumed during the scrubbing step.

In accordance with a fourth aspect, the invention provides a semiconductor device comprising:
- a conductive substrate comprising copper;
- a solderable layer provided on the conductive substrate, the solderable layer comprising silver;
- a solder layer provided on directly on the solderable layer wherein the solder layer comprises gold and germanium, and
- a semiconductor chip provided on the solder layer.

This embodiment provides an alternative solution to reducing the costs of the semiconductor device. The inventors have realized that when a silver layer is used as a solderable layer on the conductive substrate (flange or header), the semiconductor chip may be soldered directly onto this solderable layer using gold-germanium solder material. There is no need for providing further intermediate layers such as the gold layer and barrier layer as prescribed in US2008/0128908A1.

In accordance with a fifth aspect, the invention provides a semiconductor device comprising:
- a conductive substrate comprising copper;
- a solderable layer provided on the conductive substrate, the solderable layer comprising gold;
- a solder layer provided on directly on the solderable layer, wherein the solder layer comprises an alloy of gold and silicon, and
- a semiconductor chip provided on the solder layer.

This embodiment provides another alternative solution to reducing the costs of the semiconductor device. The inventors have realized that when a gold layer is used as a solderable layer on the conductive substrate (flange or header), the semiconductor chip may be soldered directly onto this solderable layer using the gold-silicon soldering technique as earlier described. There is no need for providing further intermediate layers such as the gold layer and barrier layer as prescribed in US2008/0128908A1. The golden solderable layer in this embodiment is not merely functioning as some sort of ductile layer, but mainly plays an important role in the manufacturing process, wherein this layer provides gold atoms that will dissolve into the silicon layer of the semiconductor chip for forming a solder bath.

An important remark with regards to all mentioned embodiments is that the silicon dies (semiconductor chips) are kept thin. The thickness should range between 30 and 70 micron in order provide satisfactory results with copper headers.

### BRIEF DESCRIPTION OF THE DRAWINGS

These and other aspects of the invention are apparent from and will be elucidated with reference to the embodiments described hereinafter. In the drawings,
**Fig. 1** shows a stage of a method of manufacturing a semiconductor device as known from the prior art;
**Fig. 2** to **Fig. 4** show different stages of a method of manufacturing a semiconductor device in accordance with the invention;
**Fig. 5** shows a semiconductor device as known from the prior art, and
**Fig. 6** shows an embodiment of a semiconductor device in accordance with the invention.

It should be noted that items which have the same reference numbers in different Figures, have the same structural features and the same functions, or are the same signals. Where the function and/or structure of such an item has been explained, there is no necessity for repeated explanation thereof in the detailed description.

### List of Reference Numerals:

- 1: (part of) semiconductor device
- 10: semiconductor chip
- 11: silicon layer
- 13: thin gold layer on back-side of substrate
- 100: conductive substrate/header/heat-sink/leadframe
- 101: copper core of conductive substrate
- 105: thick adhesion layer comprising gold
- 13': alloy layer comprising gold and silicon (formed during alloying step)
- δ1: thickness of copper core of conductive substrate
- 10': semiconductor chip in accordance with an embodiment of the invention
- 14: thick attachment layer comprising gold (second attachment layer)
- 200: conductive substrate/header/heat-sink/leadframe in accordance with an embodiment of the invention
- 201: copper core of conductive substrate
- 210: solderable surface comprising nickel-palladium-gold alloy or Ag, Cu etc
- SCRB: scrubbing direction (can be both in X and Y plane)
- 15: solder layer comprising gold and silicon
- 300: conductive substrate/header/heat-sink/leadframe
- 301: core of conductive substrate comprising copper-molybdenum alloy
- 310: copper layers within conductive substrate
- 320: thick gold layer around core
- δ1': thickness of copper layer
- δ2: thickness of core of conductive substrate
- 10": semiconductor chip in accordance with another embodiment of the invention
- 15': modified solder layer comprising gold and germanium
- 400: conductive substrate/header/heat-sink/leadframe in accordance with another embodiment of the invention
- 401: copper core
- 410: solderable layer (silver or gold)

### DETAILED EMBODIMENTS

While this invention is susceptible of embodiment in many different forms, there is shown in the drawings and will herein be described in detail one or more specific embodiments, with the understanding that the present disclosure is to be considered as exemplary of the principles of the invention and not intended to limit the invention to the specific embodiments shown and described.

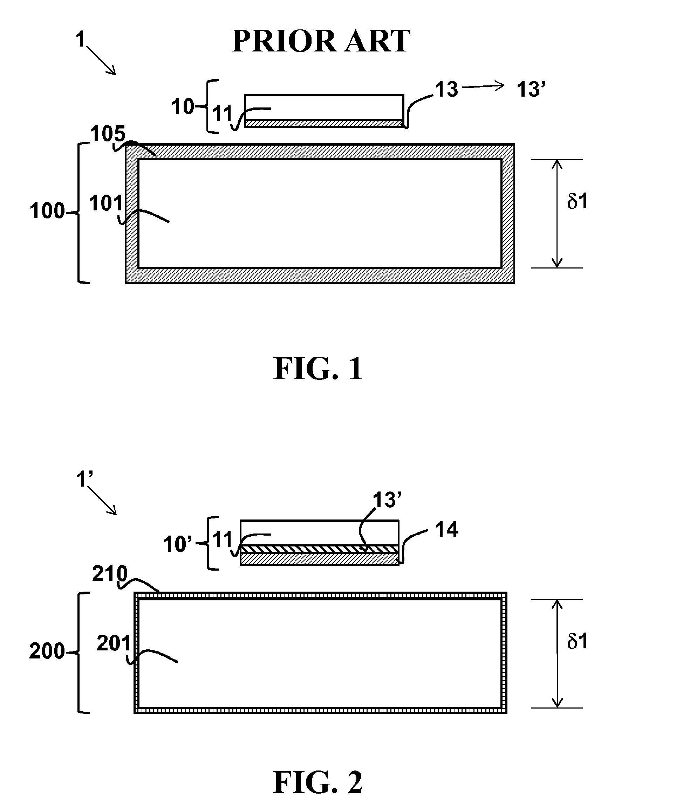

**Fig. 1** shows a stage of a method of manufacturing a semiconductor device as known from the prior art. The stage illustrated here is just before a traditional gold-silicon soldering process is carried out. The intermediate semiconductor device 1 of this figure comprises a semiconductor chip 10, which is to be attached to a conductive substrate 100, which may also be referred to as header, heat-sink, leadframe or flange. In order to render gold-silicon soldering possible a few steps have been carried out. First of all, the semiconductor chip 10 is provided with a thin gold layer 13 on the back-side, typically in the order of a few hundred nanometer, i.e. 300nm. Such layer may be typically provided by sputtering or evaporation techniques (all such techniques are well-known as such). Second, the substrate of the semiconductor chip 10 may comprise all kinds of materials, but what is important for gold-silicon soldering is that the semiconductor chip 10 at least comprises a silicon layer 11 or silicon-comprising layer at its mounting-side. Third, the conductive substrate 100 comprises a copper core and a thick adhesion layer 105 comprising gold all around the core 100. The copper core 100 has typically a thickness δ1 in the order of 1 to 1.65mm. Furthermore, the thick layer of gold 105 has typically a thickness in the range 1.5-2.5µm.

In the prior art a method of attaching a semiconductor device to a flange using a gold-silicon solder attachment technique has been reported. In this technique the thin gold layer 13 (typically 300nm) is provided on the back-side of the semiconductor chip 10, whereafter an alloying step is carried out. During the alloy step the device is heated to a high temperature (between 360°C-400°C) which makes the gold atoms to diffuse into the silicon of the silicon layer 11. At the surface a gold-silicon alloy layer 13' is being formed. Such step is typically carried out in a wafer factory and the alloying step as such is considered to be well-known to the person skilled in the art. For gold-silicon solder attachment a further gold-surface 105 is required. This gold layer 105 is provided on the flange 100. Subsequently, the semiconductor chip 10 is provided on the flange 100. The assembly is subsequently heated to a temperature of about 430°C. In this step the gold-silicon alloy layer will melt. Subsequently, the semiconductor chip 10 is scrubbed (moved hence and forth) over the flange 100, which results in the creation of a "solder bath", wherein more and more gold and silicon is dissolved into the molten gold-silicon alloy layer 13'. After cooling down the assembly, the solder bath will solidify and the solder attachment is created

**Fig. 2** to **Fig. 4** show different stages of a method of manufacturing a semiconductor device in accordance with the invention. The invention will be discussed in as far as it differs from the prior art as illustrated in **Fig. 1. Fig. 2** shows a stage of the method in which the soldering has not yet been carried out yet comparable to the stage of **Fig. 1****.** A first main difference is that the thin gold layer 13 (first attachment layer) has been alloyed, such that it has turned into a gold-silicon alloy layer 13'. A second main difference is that the semiconductor chip 10' has been further adapted in that it has been provided with a thick attachment layer 14 comprising gold (second attachment layer) on the alloy layer 13'. Such layer may be typically provided by sputtering, evaporation techniques, or plating techniques. A third main difference is that the conductive substrate 200 is a relatively cheap substrate comprising a copper core 201 with a thin solderable surface 210 comprising nickel-palladium-gold layer stack. This layer stack 210 may have a total thickness in the range from 2. to 5.2. µm.

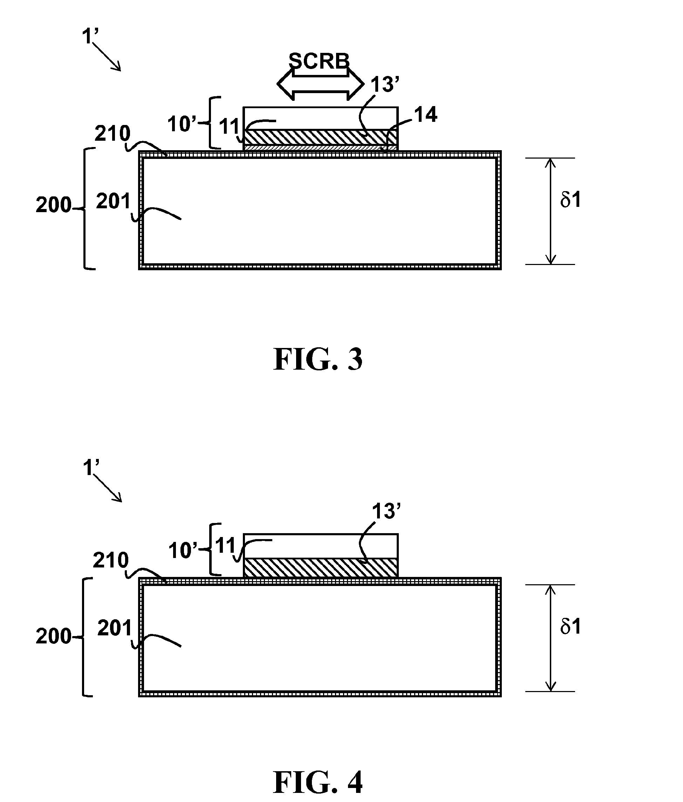

**Fig. 3** shows a stage of the method in which the soldering has not yet been carried out. In this stage the assembly has been heated as earlier described and is being scrubbed, i.e. the semiconductor chip 10' and the conductive substrate 200 are being reciprocated relative to each other as indicated by the arrow SCRB (directions parallel to the surface of the conductive substrate, so two-dimensional movements). In this step the thick gold layer 14 is being consumed, i.e. the gold diffuses into the molten alloy layer 13' (solder layer).

**Fig. 4** shows a stage of the method in which the soldering has been completed. The thick gold layer 14 has disappeared completely so that the semiconductor chip 10' is attached to the conductive substrate 200 via the thickened and solidified gold-silicon alloy layer 13'. The method as illustrated in **Fig. 2** to **Fig. 4** constitutes a significant improvement over the prior art method. The inventors have discovered that, rather than providing the second attachment layer 105 (typically a relatively thick gold) layer on the conductive substrate 100 (flange or header), this gold layer 14 can be provided on the back-side of the die, over the gold-silicon alloy layer 13'. The process steps to be carried out further are effectively the same as in the prior art. A first major advantage of this method is that the amount of gold that is used is significantly reduced. A second major advantage is that the method of the invention renders it possible to use much cheaper conductive substrates having standard cheaper solderable layers, such as silver or nickel-palladium-gold alloy.

In a further variant of the embodiment of **Fig. 4****,** there may be provided a ductile layer underneath the adhesion layer 210 (thus in between the copper core 201 and the adhesion layer 210). Such layer may comprise materials such as silver, or alloys of silver and copper. It may be provided on a top surface of the copper core 201 only at least underneath the semiconductor chip 10'.

The invention particularly relates to the fabrication of discrete power packages. As already discussed earlier in this description continuous cost reduction of discrete power packages requires innovative steps in package concepts and assembly processes.

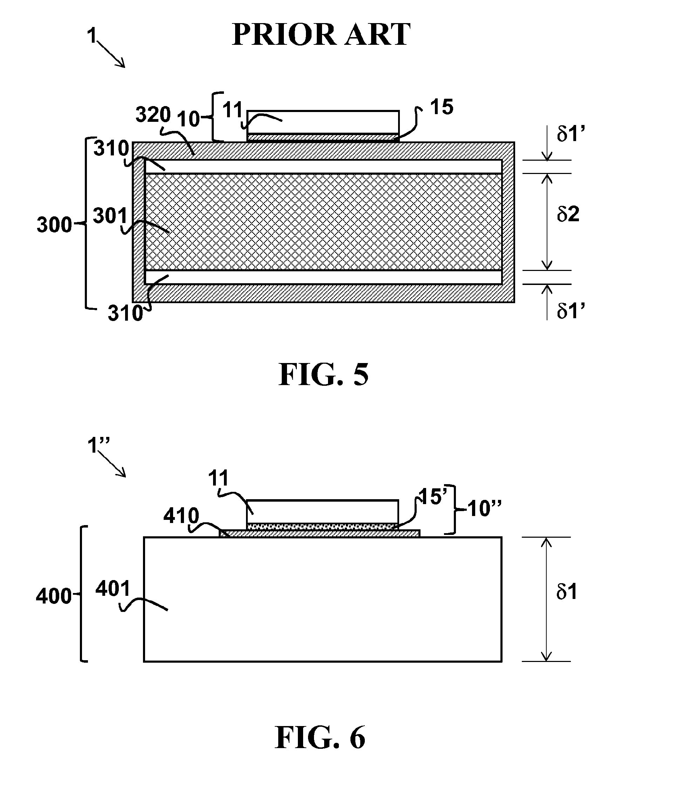

Known packaging technologies make use of header/flange/heatsink materials which combine low CTE with relative high thermal conductivity. Examples of such materials are Copper-Pressed-Copper (CPC), and copper-tungsten (CuW). CPC headers are a sandwich of layers. The top and bottom layers are Cu layers and in between these two layers a CuMo alloy layer. These header types are costly due to the delivery format (single units) and material availability and a low cost replacement would be beneficial for the complete package portfolio of the business line. **Fig. 5** shows a semiconductor device having such sandwich structure. The conductive substrate 300 comprises a core comprising copper-molybdenum alloy sandwiched between two copper cladding layers 310. Furthermore, a thick gold layer 320 is covering all sides of the conductive substrate 300. For a reliable die interconnect a relative thick gold layer is required. The thickness of this gold layer is in the range of 1.5-2.5µm. The inventors have realized that omitting this gold layer is a second opportunity in reducing the package cost. The thickness δ1' of the copper layers 310 is typically in the range of 0.150 to 0.2mm. The thickness δ2 of the core 301 is typically in the range of 0.650mm to 0.700mm.

Dies are typically soldered on these headers with a eutectic AuSi diebond process. Such process has already been discussed earlier in this description. In **Fig. 5** a solder layer 15 has been drawn, which effectively is an alloy layer obtained after alloying a thin gold layer on the back-side of the semiconductor chip 10.

The inventors have realized that the same problem (the use of a very expensive thick gold layer) may also be solved in a different way, namely as illustrated in **Fig. 6****.** This figure shows an embodiment of a semiconductor device in accordance with the invention. The figure discloses a semiconductor chip 10", which is attached to a conductive substrate 400, which mainly comprises a copper core 401 having a solderable layer 410 provided on top. The solderable layer 410 comprises silver. 410 is not really acting as a ductile layer but primarily functions as a solderable surface Ag layer thickness is 2-5mu The invention have discovered that it is possible to directly solder on this silver layer 410 using gold-germanium solder 15'. There is no need for further layers in between as the prior art teaches. A strongly simplified assembly is hereby obtained, which is also a lot cheaper. Alternatively, the solderable layer 410 may be provided on all surfaces of the core 401 providing good solderable surfaces on all sides. In an embodiment the gold-germanium solder 15' may be provided as a pre-applied solder layer on the back-side of the semiconductor chip 10". Such solder layer 15' may have a thickness in the range of 1.5-5 µm. The advantage of gold-germanium is that such alloy is readily available as a back-side metal layer in some wafer factories. Such solder layer 15' may be provided using evaporation or sputtering. The gold-germanium layer is not provided directly on the backside of the semiconductor chip. In order to establish a proper adhesion of this layer, there a complex stack of alloyed gold/silver/nickel is to be applied first, onto which the AuGe may be applied. The complex stack as such is not new, we are using it already for many years. It is NXP's IP, not sure whether to mention it here.

Preferably, the semiconductor chip 10" (die) has a thickness ranging between than 30µm and 70mu such that it is able to meet a more extreme temperature cycling test requirement of -65/200°C, compared to the 120µm thick dies which only meet the relaxed reliability requirement of -65/150°C.

As a variation on the embodiment of Fig. 6, the ductile layer may also be a gold layer. In such embodiment the solder layer 15' may be an alloyed layer as discussed with respect to Fig 1. Subsequently, the semiconductor chip 10" may be soldered to the conductive substrate 400 by means of the gold-silicon soldering technique as discussed in Fig. 1.

Similarly, in such embodiment, the semiconductor chip 10" (die) has a thickness ranging between 30µm and 70mu such that it is able to meet a more extreme temperature cycling test requirement of -65/200°C, compared to the 120µm thick dies which only meet the relaxed reliability requirement of -65/150°C.

Many different ways of executing the methods are possible, as will be apparent to a person skilled in the art. For example, the order of the steps can be varied or some steps may be executed in parallel. Moreover, in between steps other method steps may be inserted. The inserted steps may represent refinements of the method such as described herein, or may be unrelated to the method. Moreover, a given step may not have finished completely before a next step is started.

It should be noted that the above-mentioned embodiments illustrate rather than limit the invention, and that those skilled in the art will be able to design many alternative embodiments.

In the claims, any reference signs placed between parentheses shall not be construed as limiting the claim. Use of the verb "comprise" and its conjugations does not exclude the presence of elements or steps other than those stated in a claim. The article "a" or "an" preceding an element does not exclude the presence of a plurality of such elements. The invention may be implemented by means of hardware comprising several distinct elements, and by means of a suitably programmed computer. In the device claim enumerating several means, several of these means may be embodied by one and the same item of hardware. The mere fact that certain measures are recited in mutually different dependent claims does not indicate that a combination of these measures cannot be used to advantage.

## Claims

1. A method of manufacturing a semiconductor device (1'), the method comprising:
- providing a semiconductor chip (10') comprising a silicon layer (11) at a side thereof, and further comprising a first attachment layer (13) directly provided on the silicon layer (11), wherein the first attachment layer (13) comprises gold, wherein the semiconductor chip (10') comprises an active element;
- heating the semiconductor chip (10') to above a predefined temperature at which the gold of the first attachment layer (13) diffuses into the silicon layer (11) forming an alloy layer (13') comprising gold-silicon alloy consuming the first attachment layer (13), wherein the heating is carried out until the first attachment layer (13) has been fully consumed;
- providing a second attachment layer (14) directly on the alloy layer (13'), wherein the second attachment layer (14) comprises gold;
- providing a conductive substrate (200) with a solderable surface for receiving the semiconductor chip (10');
- providing the semiconductor chip (10') on a surface of the conductive substrate (200) such that the second attachment layer (14) contacts the conductive substrate (200) forming an assembly;
- heating the assembly to a further predefined temperature above a melting point of the alloy layer (13') forming a molten alloy layer;
- reciprocating, while maintaining the further temperature, the semiconductor chip (10') with respect to the conductive substrate (200) such that their surfaces are scrubbing each other, in which reciprocating step a solder layer is being formed comprising the molten alloy layer (13') and gold originating from the second attachment layer (14) consuming the second attachment layer (14), and the solder layer (13') being formed further comprising silicon originating from the silicon layer (11), and which reciprocating step is continued until the second attachment layer (14) is fully consumed such that the molten alloy layer (13') touches the conductive substrate (200), and
- cooling down the assembly such that the solder layer (13') solidifies and a solder attachment has been formed between the conductive substrate (200) and the semiconductor chip (10').

2. The method as claimed in claim 1, wherein the first attachment layer (13) on semiconductor chip (10') is chosen with a thickness in the range from 150nm to 300nm.

3. The method as claimed in claim 1 or 2, wherein the attachment second layer (14) on the alloy layer (13') is chosen with a thickness in the range from 1.5µm to 2.5µm

4. The method as claimed in any one of the preceding claims, wherein the predefined temperature is chosen in the range from 360°C to 400°C.

5. The method as claimed in any one of the preceding claims, wherein the further predefined temperature is chosen in the range from 400°C to 450°C.

6. A semiconductor device (1') comprising an assembly obtainable via the method as claimed in any one of the preceding claims, wherein the assembly comprises the semiconductor chip (10') and the conductive substrate (200).

7. A semiconductor device (1') comprising:
- a conductive substrate (200);
- a solder layer (13') provided on the conductive substrate (200), wherein the solder layer (13') comprises an alloy of gold and silicon;
- a semiconductor chip (10') provided on the solder layer (13'), wherein the semiconductor chip (10') comprises an active element.

8. A semiconductor device (1 ") comprising:
- a conductive substrate (400) comprising copper;
- a solderable layer (410) provided on the conductive substrate (400), the solderable layer (410) comprising silver;
- a solder layer (15') provided on directly on the solderable layer (410), wherein the solder layer (15') comprises gold and germanium, and
- a semiconductor chip (10') provided on the solder layer (15').

9. A semiconductor device (1 ") comprising:
- a conductive substrate (400) comprising copper;
- a solderable layer (410) provided on the conductive substrate (400), the solderable layer (410) comprising gold;
- a solder layer (15') provided on directly on the solderable layer (410), wherein the solder layer (15') comprises an alloy of gold and silicon, and
- a semiconductor chip (10') provided on the solder layer (15').
